# EUROPEAN PATENT SPECIFICATION

(11) **EP 0 449 156 B1**
(45) Date of publication and mention of the grant of the patent: **27.10.1993**
(21) Application number: 91104610.0
(22) Date of filing: 24.03.1991
(51) Int. Cl.: B23K 3/047

(54) **Soldering apparatus and method employing provision of heated gas to a soldering alloy at a soldering collection**
Lötvorrichtung und Verfahren unter Verwendung eines erwärmten Gases an einer Lotlegierung für eine zusammenzulötende Teileanordnung
Appareil à braser et procédé employant du gaz chauffé sur un alliage à braser dans un arrangement de pièces à braser

(30) Priority: 28.03.1990 IT 4780190
(43) Date of publication of application: 02.10.1991
(73) Proprietor: SELENIA INDUSTRIE ELETTRONICHE ASSOCIATE S.p.A., I-00131 Roma (IT)
(72) Inventor: Moretti, Sergio, I-00010 Roma (IT); Fracassi, Ugo, I-00172 Roma (IT)
(74) Representative: Gustorf, Gerhard, Dipl.-Ing.

(56) References cited:
- EP-A- 0 023 599
- GB-A- 2 185 432

## Description

The invention takes regard for a chip soldering system adopting soldering alloys, suitable for microelectronic applications.

This invention is presented in a configuration according to which an inert gas flow is delivered to a chamber through a ring slot, so that the flow can reach the area of interest for microchip soldering in a uniform manner.

The invention belongs to the microelectronics field, more specifically to that of soldering of chips onto microcircuits.

Previous solutions (see for example GB-A- 2 185 432) had a few drawbacks, such as:
- during soldering oxidizing phenomena affected the alloy because air was entrained with the inert flow;
- the operator had to pay great attention while carrying out the soldering operation;
- the operation was tied to the different meling temperatures.

The innovation presented solves such drawbacks thanks to its configuration.

The invention will now be described with illustrative purposes, with reference to a form of implementation wich is presently preferred by the inventors.

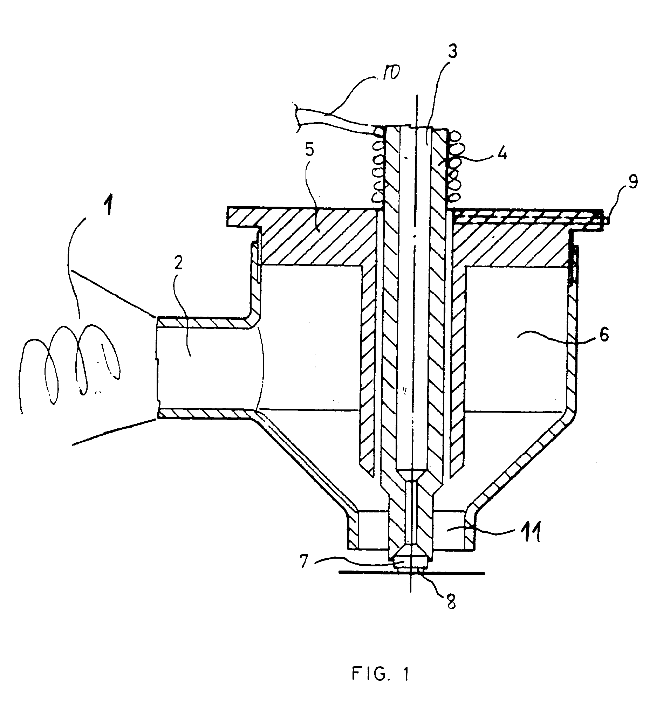

Figure 1 shows a section of the nozzle, and in particular :
1 Thermoresistor for gas temperature regulation;
2 Gas nozzle;
3suction channel to hold the chip to be soldered;
4point to hold the chips;
5flow regulation support;
6annular chamber for inert gas distribution;
7element (chip) to be soldered;
8soldering alloy;
9fixing screw;
10heater element.

It is to be noted that the invention exploits rules governing gas flow.

The gas in fact enters into the chamber from an external source; it is collected within the chamber 6 and once filled, the jet exits the chamber 6 from the annular aperture 11 with an even pressure over all of its points.
As it is facing the point hosting the element to be soldered, it melts the soldering alloy and upon conclusion of the operation, the jet stops automatically under the control of a timer.

The inert gas input system, which protects the solder from oxidizing through an annular nozzle, is already used in electic arc welders, but in this case it is used to perform soldering by means of hot gasses.

In the following , some of the advantages brought about by the invention in subject are listed:
- the solder does not oxidize while soldering;
- the uniform pressure of the gas is such that the soldering alloy does not form any irregularities;
- repetitive soldering are possible;
- a set of such nozzles can perform more than one soldering at the same time;
- it is possible to perform microscopic soldering because the jet comes from above and the chip to be soldered does not suffer and shift even when extremely small;
- the process can be performed automatically by means of a suitable software programme.

## Claims

1. Soldering system, particularly suited for the soldering of chips (7) by means of soldering alloys (8), and comprising the following parts:
- a thermoresistor (1) for inert gas heating and temperature regulation ;
- a gas nozzle (2) receiving the heated gas ;
- a point (4) incorporated in the nozzle (2) and comprising a sucking channel (3) to pick up and hold the chips(7) ;
- a heater (10) for heating the point (4) ;
- a flow regulation support (5) for regulating the gas flow ;
- a fixing screw (9) for fixing the point (4) into the flow regulation support (5).

2. Soldering system according to claim 1 and comprising a set of nozzles (2).

3. Soldering system according to claim 1 and comprising computerized controls.

## Patentansprüche

1. Lötsystem, insbesondere zum Löten von Chips (7) mittels einer Lötlegierung (8), umfassend die folgenden Bestandteile:
- einen Heizwiderstand (1) zum Erhitzen eines Inertgases und zur Temperaturregulierung;
- eine das erhitzte Gas aufnehmende Gasdüse (2);
- eine in der Gasdüse (2) eingebaute Spitze (4) mit einem Saugkanal (3) zum Aufnehmen und Halten der Chips (7);
- ein Heizelement (10) zum Erwärmen der Spitze (4);
- einen Tragkörper (5) zum Regulieren des Gasdurchflusses;
- eine Befestigungsschraube (9) zum Fixieren der Spitze (4) in dem Durchflußregulierungs-Tragkörper (5).

2. Lötsystem nach Anspruch 1 mit einem Satz Düsen (2).

3. Lötsystem nach Anspruch 1 mit rechnergesteuerten Regelungen.

## Revendications

1. Système de brasage, convenant en particulier pour le brasage de plaquettes (7) au moyen d'alliages de brasage (8), et comportant les parties suivantes:
- une résistance thermique (1) pour chauffer le gaz inerte et en réguler la température;
- une buse à gaz (2) recevant le gaz chauffé;
- une aiguille (4) incorporée dans la buse (2) et comprenant un canal d'aspiration (3) pour attirer et maintenir les plaquettes (7);
- un élément chauffant (10) pour chauffer l'aiguille (4);
- un support (5) de régulation de flux pour réguler le flux de gaz;
- une vis de fixation (9) pour fixer l'aiguille (4) dans le support (5) de régulation de flux.

2. Système de brasage selon la revendication 1, et comportant un jeu de buses (2).

3. Système de brasage selon la revendication 1, et comportant des commandes par ordinateur.
